# EUROPEAN PATENT APPLICATION

(11) **EP 4 838 460 A1**
(43) Date of publication of application: **11.11.2026**
(21) Application number: 26169356.8
(22) Date of filing: 31.03.2026
(51) Int. Cl.: G06T 7/00

(54) **AUTOMATIC REPAIR SYSTEMS, DISPLAY MODULE MANUFACTURED THEREBY, ELECTRONIC DEVICE MANUFACTURED THEREBY**

(30) Priority: 08.05.2025 KR 20250059628
(71) Applicant: Samsung Display Co., Ltd., Yongin-si, Gyeonggi-do 17113 (KR)
(72) Inventor: Kim, Seunggi, Yongin-si, Gyeonggi-do (KR); Kim, Haneol, Yongin-si, Gyeonggi-do (KR); Kim, Eunwoo, Yongin-si, Gyeonggi-do (KR); Kim, Young-Bae, Yongin-si, Gyeonggi-do (KR); Seo, Jaejong, Yongin-si, Gyeonggi-do (KR); Lee, Jinho, Yongin-si, Gyeonggi-do (KR); Jung, Inho, Yongin-si, Gyeonggi-do (KR)
(74) Representative: Gulde & Partner

(57) **Abstract**

An automatic repair system includes a stage, an imaging device, a processor, and a repair device. The stage supports a substrate including a display panel and a touch insulation layer disposed on the display panel. The imaging device captures a first portion of the substrate to generate a high-magnification image. The processor performs operations using a defect-detection artificial intelligence (AI) model. The defect-detection AI model analyzes an image captured by the imaging device to identify a location on the substrate at which a defect occurs. The repair device provides a metallic material on the touch insulation layer.

## Description

This application claims priority to Korean Patent Application No. 10-2025-0059628, filed on May 8, 2025, the content of which in its entirety is herein incorporated by reference.

### BACKGROUND

### 1. Field

The present disclosure relates to an automatic repair system configured to automatically perform a repair process, a method of operating said automatic repair system, a display module manufactured by the automatic repair system, and an electronic device manufactured by the automatic repair system.

### 2. Description of the Related Art

A repair process is a process of detecting and correcting defects that occur in a display module. By performing the repair process, the defect rate and manufacturing cost of the display module can be reduced. In order to reduce the aforementioned defect rate and manufacturing cost, it may be desired to automate the repair process. However, conventional automation of the repair process has been limited to only a part of the repair process (e.g., defect detection).

### SUMMARY

Embodiments of the present disclosure provide an automatic repair system configured to automate an entire repair process, a method of operating said automatic repair system (i.e., a 'repair process'), a display module manufactured by the automatic repair system, and an electronic device manufactured by the automatic repair system.

An automatic repair system according to an embodiment of the present disclosure includes a stage, an imaging device, a processor, and a repair device. In such an embodiment, the stage is configured to support a substrate including a display panel and a touch insulation layer disposed on the display panel. In such an embodiment, the imaging device is configured to capture a first portion of the substrate and generate a high-magnification image. In such an embodiment, the processor is configured to perform processing using a defect-detection artificial intelligence (AI) model. In such an embodiment, the defect-detection AI model is capable of analyzing the image captured by the imaging device and locating a position on the substrate at which a defect occurs. In such an embodiment, the repair device is configured to provide a metallic material on the touch insulation layer or radiate a laser to a portion of the touch insulation layer corresponding to the first target region.

In such an embodiment, when the processor locates a first target position on the substrate at which a defect occurs from the high-magnification image using the defect-detection AI model, the processor is configured to define a first target region including the first target position. In such an embodiment, the repair device is configured to provide the metallic material on a portion of the touch insulation layer corresponding to the first target region or radiate the laser to a portion of the touch insulation layer corresponding to the first target region.

In such an embodiment, when the processor fails to locate the first target position on the substrate from the high-magnification image using the defect-detection AI model, the imaging device is configured to capture a second portion of the substrate including the first portion and generate a low-magnification image. In such an embodiment, the second portion has a larger area than the first portion.

When the processor locates a second target position on the substrate at which a defect occurs from the low-magnification image using the defect-detection AI model, the processor may be configured to define a second target region including the second target position. The repair device may be configured to provide the metallic material on a portion of the touch insulation layer corresponding to the second target region.

The processor may be configured to define each of the first target region and the second target region using at least one selected from an iterative algorithm and a region-defining AI model. The region-defining AI model may be a deep-learning-based reinforcement learning model.

After the metallic material is provided by the repair device, the imaging device may be configured to capture a portion of the touch insulation layer corresponding to the first target region and generate a post-inspection image. The processor may be configured to perform processing using a post-inspection AI model. The post-inspection AI model may be configured to analyze the post-inspection image and determine whether the first target position overlaps the metallic material.

When it is determined that the metallic material is not provided in the first target region, the repair device may be configured to provide the metallic material in the first target region.

When the first target region is provided in plural, the repair device may be configured to provide the metallic material on portions of the touch insulation layer corresponding to the plurality of first target regions. The processor may be configured to analyze the post-inspection image using the post-inspection AI model and determine whether there is a portion of the touch insulation layer on which the metallic material is provided more than once.

The processor may be configured to analyze the post-inspection image using the post-inspection AI model and determine whether the first target position overlaps an edge / an outline of the metallic material.

The processor may be configured to perform processing using a diffusion-based image-generation AI model. The image-generation AI model may be configured to generate virtual training data using an input image. The post-inspection AI model may be configured to be trained by supervised learning using the virtual training data.

The image-generation AI model may be configured to generate a first virtual image in a first region of the input image and generate a second virtual image in a second region of the input image different from the first region.

The display panel may include a base member, a circuit layer, a light-emitting diode (LED) layer, and an encapsulation layer. The circuit layer may be disposed on the base member. The circuit layer may include a transistor. The LED layer may include a pixel defining layer, in which an opening is defined, and a light-emitting layer disposed in the opening. The pixel defining layer may cover at least a portion of the circuit layer. The encapsulation layer may cover the LED layer. A touch insulation layer may be disposed on the encapsulation layer.

An automatic repair system according to an embodiment of the present disclosure includes a stage, an imaging device, a processor, and a repair device. In such an embodiment, the stage is configured to support a substrate including a display panel and a touch insulation layer disposed on the display panel. In such an embodiment, the imaging device is configured to capture a first portion of the substrate and generate a high-magnification image. In such an embodiment, the processor is configured to analyze the image captured by the imaging device, locate a first target position on the substrate at which a defect occurs, and define a first target region including the first target position. In such an embodiment, the repair device is configured to provide a metallic material on, or radiate a laser to, a portion of the touch insulation layer corresponding to the first target region. In such an embodiment, after the metallic material is provided by the repair device, the imaging device is configured to capture the portion of the touch insulation layer corresponding to the first target region and generate a post-inspection image. In such an embodiment, the processor is configured to perform processing using a post-inspection artificial intelligence (AI) model. In such an embodiment, the post-inspection AI model is configured to analyze the post-inspection image and determine whether the first target position overlaps the metallic material.

The processor may be configured to perform processing using a diffusion-based image-generation AI model. The image-generation AI model may be configured to generate virtual training data using an input image. The post-inspection AI model may be trained by supervised learning based on the virtual training data.

The image-generation AI model may be configured to generate a first virtual image in a first region of the input image and generate a second virtual image in a second region of the input image different from the first region.

When the processor fails to locate the first target position on the substrate from the high-magnification image, the imaging device may be configured to capture a second portion of the substrate including the first portion and generate a low-magnification image. The second portion may have a larger area than the first portion. When the processor locates a second target position on the substrate from the low-magnification image, the processor may be configured to define a second target region including the second target position. The repair device may be configured to provide the metallic material on a portion of the touch insulation layer corresponding to the second target region or radiate a laser to a portion of the touch insulation layer corresponding to the second target region.

The processor may be configured to perform processing using a defect-detection artificial intelligence (AI) model. The defect-detection AI model may be configured to analyze an image captured by the imaging device and locate a position on the substrate at which a defect occurs. The processor may be configured to define each of the first target region and the second target region using at least one selected from an iterative algorithm and a region-defining AI model. The region-defining AI model may be a deep-learning-based reinforcement learning model.

The processor may be configured to perform processing using a composite AI model. The composite AI model may locate the first target position from the high-magnification image and define the first target region including the first target position.

When it is determined that the metallic material is not provided in the first target region, the repair device may be configured to provide the metallic material in the first target region.

When the first target region is provided in plural, the repair device may be configured to provide the metallic material on portions of the touch insulation layer corresponding to the plurality of first target regions. The processor may be configured to analyze a post-inspection image using the post-inspection AI model and determine whether any portion of the touch insulation layer has the metallic material disposed thereon more than once.

The processor may be configured to analyze the post-inspection image using the post-inspection AI model and determine whether the first target position overlaps an edge or outline of the metallic material.

The display panel may include a base member, a circuit layer, a light-emitting diode (LED) layer, and an encapsulation layer. The circuit layer may be disposed on the base member. The circuit layer may include a transistor. The LED layer may include a pixel-defining layer, in which an opening is defined, and a light-emitting layer disposed in the opening. The pixel-defining layer may cover at least a portion of the circuit layer. The encapsulation layer may cover the LED layer. A touch insulation layer may be disposed on the encapsulation layer.

A method according to an embodiment of the present disclosure comprises a stage STG which is configured to support a substrate SBT including a display panel DP and a touch insulation layer IL disposed on the display panel DP; an imaging device CMR which is configured to capture a first portion of the substrate SBT and generate a high-magnification image; a processor PRC which is configured to perform processing using a defect-detection artificial intelligence, AI, model SMD capable of analyzing an image captured by the imaging device CMR and locating a position at which a defect occurs in the substrate SBT; and a repair device RPM which is configured to provide a metallic material on the touch insulation layer IL or radiate a laser to a portion of the touch insulation layer corresponding to the first target region,
wherein the method comprises the following steps:
when the processor PRC locates a first target position TGP1 at which a defect occurs on the substrate SBT from the high-magnification image using the defect-detection AI model SMD, the processor PRC defines a first target region TGA1 including the first target position TGP1, and the repair device RPM provides the metallic material on a portion of the touch insulation layer IL corresponding to the first target region TGA1 or radiates a laser to a portion of the touch insulation layer corresponding to the first target region, and
when the processor PRC fails to locate the first target position TGP1 at which the defect occurs on the substrate SBT from the high-magnification image using the defect-detection AI model SMD, the imaging device CMR captures a second portion of the substrate SBT including the first portion and generates a low-magnification image, wherein the second portion has a larger area than the first portion.

The method may further include the steps of, when the processor PRC locates a second target position TGP2 at which a defect occurs on the substrate SBT from the low-magnification image using the defect-detection AI model SMD, the processor PRC defines a second target region TGA2 including the second target position TGP2, and the repair device RPM provides the metallic material on a portion of the touch insulation layer IL corresponding to the second target region TGA2.

The method may further include the steps of, wherein the processor PRC defines each of the first target region TGA1 and the second target region TGA2 using at least one selected from an iterative algorithm and a region-defining artificial intelligence, AI, model DMD, and
wherein the region-defining AI model DMD is an artificial intelligence model trained using a deep-learning-based reinforcement learning method.

The method may further include the steps of, wherein the imaging device CMR captures a portion of the touch insulation layer IL corresponding to the first target region TGA1 to generate a post-inspection image, after the metallic material is provided by the repair device RPM, and
wherein the processor PRC performs processing using a post-inspection artificial intelligence, AI, model TMD configured to analyze the post-inspection image and determines whether the first target position TGP1 overlaps the metallic material.

The method may further include any of the steps outlined above in relation to the automatic repair system.

A display module according to an embodiment of the present disclosure includes a base member, a circuit layer, a light-emitting diode (LED) layer, an encapsulation layer, and a touch-detection circuit. In such an embodiment, the circuit layer is disposed on the base member and may include a transistor. In such an embodiment, the LED layer includes a pixel-defining layer, in which an opening is defined, and a light-emitting layer disposed in the opening. In such an embodiment, the pixel-defining layer covers at least a portion of the circuit layer. In such an embodiment, the encapsulation layer covers the LED layer. In such an embodiment, the touch-detection circuit is disposed on the encapsulation layer. In such an embodiment, the touch-detection circuit includes an intermediate touch insulation layer, a protective member, a first touch-detection electrode, an upper touch insulation layer, and a second touch-detection electrode. In such an embodiment, the intermediate touch insulation layer is disposed on the encapsulation layer. In such an embodiment, the protective member is disposed between the encapsulation layer and the intermediate touch insulation layer and includes a metallic material. In such an embodiment, the first touch-detection electrode is disposed on the intermediate touch insulation layer. In such an embodiment, the upper touch insulation layer covers the first touch-detection electrode. In such an embodiment, at least a portion of the second touch-detection electrode is disposed on the upper touch insulation layer.

The display module may further include a predetermined structure located in the encapsulation layer. The predetermined structure may overlap the protective member and may include a material different from a material of the encapsulation layer.

An inner region and an outer region surrounding the inner region may be defined in the protective member when viewed in a plan view. The portion of the predetermined structure which is farthest from the base member may overlap the inner region and may not overlap the outer region.

A first length of the predetermined structure measured in a predetermined direction may be smaller than a length of the protective member measured in the predetermined direction.

The touch-detection circuit may further include a lower touch insulation layer disposed between the encapsulation layer and the intermediate touch insulation layer. The protective member may be disposed between the encapsulation layer and the lower touch insulation layer or between the lower touch insulation layer and the intermediate touch insulation layer.

An electronic device according to an embodiment of the present disclosure includes a display module, a processor, and a power module. In such an embodiment, the display module emits light. In such an embodiment, the processor controls the display module. In such an embodiment, data for operating at least one selected from the display module and the processor is stored in a memory. In such an embodiment, the power module generates or supplies power. In such an embodiment, the display module includes a base member, a circuit layer, a light-emitting diode (LED) layer, an encapsulation layer, and a touch-detection circuit. In such an embodiment, the circuit layer is disposed on the base member and includes a transistor. In such an embodiment, the LED layer includes a pixel-defining layer and a light-emitting layer. In such an embodiment, an opening is defined in the pixel-defining layer, and the light-emitting layer is disposed in the opening. In such an embodiment, the pixel-defining layer covers at least a portion of the circuit layer. In such an embodiment, the encapsulation layer covers the LED layer.

In such an embodiment, the touch-detection circuit is disposed on the encapsulation layer and includes an intermediate touch insulation layer, a protective member, a first touch-detection electrode, an upper touch insulation layer, and a second touch-detection electrode. In such an embodiment, the intermediate touch insulation layer is disposed on the encapsulation layer. In such an embodiment, the protective member is disposed between the encapsulation layer and the intermediate touch insulation layer and includes a metallic material. In such an embodiment, the first touch-detection electrode is disposed on the intermediate touch insulation layer. In such an embodiment, the upper touch insulation layer covers the first touch-detection electrode. In such an embodiment, at least a portion of the second touch-detection electrode is disposed on the upper touch insulation layer.

The electronic device may further include a predetermined structure located in the encapsulation layer. The predetermined structure may overlap the protective member and may include a material different from a material of the encapsulation layer.

An inner region and an outer region surrounding the inner region may be defined in the protective member when viewed in a plan view. A portion of the predetermined structure which is farthest from the base member may overlap the inner region and may not overlap the outer region.

A length of the predetermined structure measured in a predetermined direction may be smaller than a length of the protective member measured in the predetermined direction.

The touch-detection circuit may further include a lower touch insulation layer disposed between the encapsulation layer and the intermediate touch insulation layer. The protective member may be disposed between the encapsulation layer and the lower touch insulation layer or between the lower touch insulation layer and the intermediate touch insulation layer.

The encapsulation layer may include a first inorganic encapsulation layer, an organic encapsulation layer, and a second inorganic encapsulation layer. The first inorganic encapsulation layer may include a first inorganic insulating material and may cover the LED layer. The organic encapsulation layer may include an organic insulating material and may cover at least a portion of the first inorganic encapsulation layer. The second inorganic encapsulation layer may include a second inorganic insulating material and may be disposed on the organic encapsulation layer.

The encapsulation layer may include a first inorganic encapsulation layer, an organic encapsulation layer, and a second inorganic encapsulation layer. In such an embodiment, the first inorganic encapsulation layer may include a first inorganic insulating material and may cover the LED layer. The organic encapsulation layer may include an organic insulating material and may cover at least a portion of the first inorganic encapsulation layer. The second inorganic encapsulation layer may include a second inorganic insulating material and may be disposed on the organic encapsulation layer.

According to embodiments of the present disclosure, there may be provided an automatic repair system configured to automate an entire repair process, a method of operating the same, a display module manufactured by the automatic repair system, and an electronic device manufactured by the automatic repair system.

### BRIEF DESCRIPTION OF THE DRAWINGS

These and/or other features of embodiments of the disclosure will become apparent and more readily appreciated from the following description of embodiments, taken in conjunction with the accompanying drawings, in which:
FIG. 1A is a perspective view illustrating an automatic repair system according to an embodiment of the present disclosure;
FIG. 1B is a block diagram illustrating the automatic repair system of FIG. 1A;
FIG. 2A is a cross-sectional view illustrating a substrate according to an embodiment of the present disclosure;
FIG. 2B is a cross-sectional view illustrating a substrate according to another embodiment of the present disclosure;
FIG. 3A is a cross-sectional view illustrating a display module manufactured using the substrate of FIG. 2A;
FIG. 3B is a cross-sectional view illustrating a display module manufactured using the substrate of FIG. 2B;
FIG. 4A is an example of a high-magnification image generated by the imaging device;
FIG. 4B is an enlarged view of a portion of the high-magnification image of FIG. 4A;
FIG. 4C illustrates an example of a first target region including a first target position;
FIG. 5A is an example of a second high-magnification image generated by the imaging device by capturing a second portion of the substrate;
FIG. 5B is an example of a first low-magnification image generated by the imaging device by capturing a third portion of the substrate;
FIG. 5C is an example of a third high-magnification image generated by the imaging device by capturing a fourth portion of the substrate;
FIG. 5D illustrates an example of a second target region including a second target position;
FIG. 6A illustrates an example of a fourth high-magnification image generated by the imaging device by capturing the substrate;
FIG. 6B illustrates an example of a mask image generated by the processor using the fourth high-magnification image;
FIG. 7 illustrates an example of a third target region and a fourth target region defined by the processor using the mask image;
FIGS. 8A to 8E illustrate post-inspection images generated by capturing target regions in which metallic material are disposed after the repair process has been performed;
FIGS. 9A to 9F illustrate a process of generating virtual training data;
FIG. 10 is an example block diagram illustrating an automatic repair system according to an embodiment of the present disclosure;
FIG. 11A is an example block diagram illustrating an electronic device according to an embodiment of the present disclosure; and
FIG. 11B illustrates examples of electronic devices according to embodiments of the present disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

When an element (or region, layer, portion, or the like) is described to be "disposed on," "placed on," "arranged on," "connected to," or "coupled to" another element, it shall be construed as being disposed on, placed on, arranged on, connected to, or coupled to the other element directly but also as possibly having another element therebetween. If one element is described to be "directly disposed on," "directly placed on," "directly arranged on," "directly connected to," or "directly coupled to" another element, it shall be construed that there is no other element interposed therebetween.

Like or identical reference numerals refer to like or identical elements. Moreover, in the accompanying drawings, the thicknesses, ratios, and dimensions of the elements may not be to exact scale and may have been exaggerated for the benefit of effective explanation of the technical features associated with these elements. As such, the present disclosure shall not be restricted to the thicknesses, ratios, dimensions, characteristics, and the like illustrated in the drawings.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Moreover, relative terms, such as "below," "under," "beneath," "lower," "bottom," "above," "over," "upper," "top," and the like may be used herein to describe one element's relationship to another element as illustrated in the accompanying figures. It shall be understood that relative terms are intended to encompass different orientations of the device in addition to the orientation depicted in the accompanying figures. For example, if the device in one of the figures is turned over, elements described as being on the "lower" side of the other elements would then be oriented on "upper" sides of the other elements. The example term "lower" can therefore encompass an orientation of both "lower" and "upper," depending on the particular orientation of the figure. Similarly, if the device in one of the figures is turned over, elements described as "below" or "beneath" other elements would then be oriented "above" the other elements. The example term "below" or "beneath" can therefore encompass an orientation of both above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms, including technical terms and scientific terms, used herein have the same meaning as how they are generally understood by those of ordinary skill in the art to which the present disclosure pertains. Any term that is defined in a general dictionary shall be construed to have the same meaning in the context of the relevant art, and, unless otherwise defined explicitly, shall not be interpreted to have an idealistic or excessively formalistic meaning.

In the present specification, if any embodiment can be differently implemented, the specified order of process may be performed differently than the described order. For example, two processes described to be performed sequentially may be performed simultaneously or performed in a reverse order.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

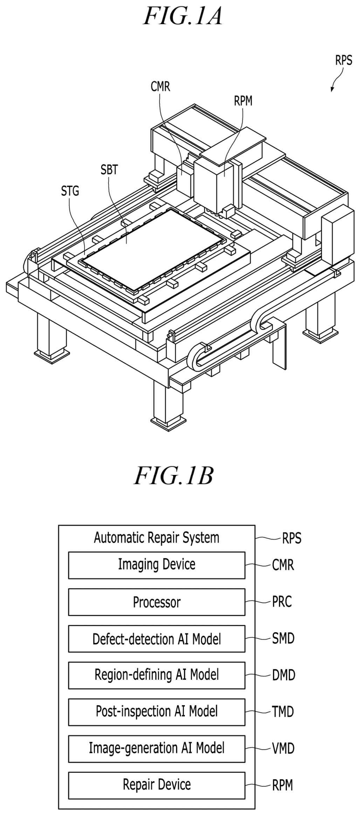

FIG. 1A is a perspective view illustrating an automatic repair system RPS according to an embodiment of the present disclosure. FIG. 1B is a block diagram illustrating the automatic repair system RPS of FIG. 1A.

Referring to FIGS. 1A and 1B, the automatic repair system RPS according to an embodiment of the present disclosure includes a stage STG, an imaging device CMR, a processor PRC, and a repair device RPM.

The stage STG is configured to support a substrate SBT. The imaging device CMR is configured to capture the substrate SBT and generate an image.

The processor PRC may be configured to perform processing using at least one selected from a defect-detection artificial intelligence (AI) model SMD, a region-defining AI model DMD, a post-inspection AI model TMD, and an image-generation AI model VMD.

The repair device RPM is configured to perform a repair process. The repair process may be a process of converting a defective substrate SBT into a non-defective substrate. The repair process may include disposing or providing a metallic material on the substrate SBT or radiating a laser onto the substrate SBT. In another embodiment of the present disclosure, the repair process may be a chemical vapor deposition (CVD) process.

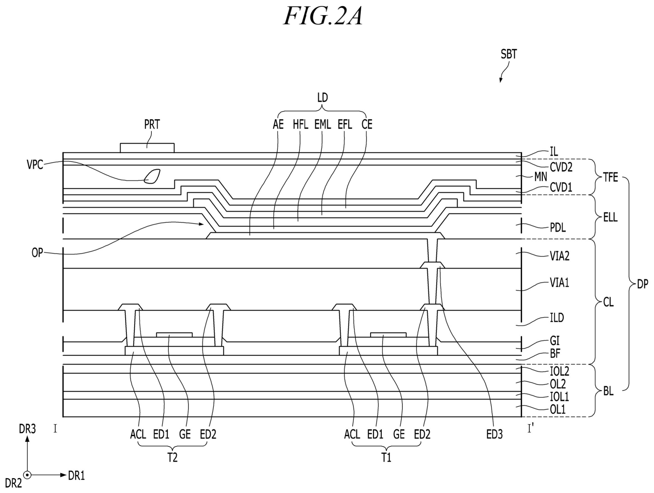

FIG. 2A is a cross-sectional view illustrating a substrate SBT according to an embodiment of the present disclosure. Referring to FIG. 2A, in an embodiment, the substrate SBT includes a display panel DP and a touch insulation layer IL.

The display panel DP may include a base member BL, a circuit layer CL, a light-emitting diode (LED) layer ELL, and an encapsulation layer TFE. The base member BL may include at least one selected from a first organic layer OL1, a first inorganic layer IOL1, a second organic layer OL2, and a second inorganic layer IOL2. The base member BL may be configured to support the circuit layer CL. That is, other components of the circuit layer CL may be stacked on the base member BL.

The first organic layer OL1 may include an organic material, such as, for example, polyimide. The first inorganic layer IOL1 may be disposed on the first organic layer OL1 and may include an inorganic material. The second organic layer OL2 may be disposed on the first inorganic layer IOL1 and may include an organic material, such as, for example, polyimide. The second inorganic layer IOL2 may be disposed on the second organic layer OL2 and may include an inorganic material.

In the base member BL, a plurality of organic layers OL1, OL2 and a plurality of inorganic layers IOL1, IOL2 may be alternately arranged. The base member BL may blocks impurities from the lower side from entering the circuit layer CL. That is, the base member BL may protect the circuit layer CL.

The circuit layer CL may include a buffer layer BF, a gate insulating layer GI, an interlayer insulating layer ILD, a first circuit insulating layer VIA1, a second circuit insulating layer VIA2, and a plurality of transistors T1, T2.

The plurality of transistors T1, T2 may transmit electrical signals. Each of the plurality of transistors T1, T2 may include an active region ACL, a first electrode ED1, a control electrode GE, and a second electrode ED2.

The buffer layer BF may be disposed on the base member BL. The buffer layer BF may effectively prevent impurities from the lower side from flowing upward. Therefore, components disposed on the buffer layer BF may be protected.

Each of the plurality of active regions ACL that constitutes each of the plurality of transistors T1, T2 may be disposed on the buffer layer BF. In an embodiment, each of the plurality of active regions ACL may include polysilicon or amorphous silicon. In an embodiment, the plurality of active regions ACL may include a metal oxide semiconductor. The plurality of active regions ACL may include a channel region serving as a path through which electrons or holes may move, and a first ion-doped region and a second ion-doped region disposed on opposite sides of the channel region.

The gate insulating layer GI may cover the buffer layer BF and the plurality of active regions ACL. The gate insulating layer GI may include an organic film and/or an inorganic film. The gate insulating layer GI may include a plurality of inorganic thin films. The plurality of inorganic thin films may include a silicon nitride layer and a silicon oxide layer.

The plurality of control electrodes GE that constitute the plurality of transistors T1, T2, respectively, may be disposed on the buffer layer BF. The plurality of control electrodes GE may overlap the plurality of active regions ACL. In an embodiment, the plurality of control electrodes GE may include molybdenum (Mo).

The interlayer insulating layer ILD may cover the gate insulating layer GI and the plurality of control electrodes GE. The interlayer insulating layer ILD may include an organic film and/or an inorganic film. The interlayer insulating layer ILD may include a plurality of inorganic thin films or organic thin films. The plurality of inorganic thin films may include a silicon nitride layer and a silicon oxide layer.

The plurality of first electrodes ED1 and the plurality of second electrodes ED2 that constitute each of the plurality of transistors T1, T2 may be disposed on the interlayer insulating layer ILD. The plurality of first electrodes ED1 and the plurality of second electrodes ED2 may be electrically connected to the plurality of active regions ACL through contact holes defined in the interlayer insulating layer ILD. In an embodiment, the first electrodes ED1 and the second electrodes ED2 may include a metal. The first electrodes ED1 and the second electrodes ED2 may have a multilayer structure. In an embodiment, for example, each of the first electrodes ED1 and the second electrodes ED2 may be formed by being stacked in the order of titanium (Ti), aluminum (Al), and titanium (Ti).

The first circuit insulating layer VIA1 may cover the interlayer insulating layer ILD, the plurality of first electrodes ED1, and the plurality of second electrodes ED2. The first circuit insulating layer VIA1 may include an organic film and/or an inorganic film. The first circuit insulating layer VIA1 may provide a planar surface.

A third electrode ED3 may be disposed on the first circuit insulating layer VIA1. The third electrode ED3 may be electrically connected to the second electrode ED2 through a contact hole defined in the first circuit insulating layer VIA1. The third electrodes ED3 may include a metal. Each of the third electrodes ED3 may have a multilayer structure. In an embodiment, for example, the third electrodes ED3 may be formed by being stacked in the order of titanium (Ti), aluminum (Al), and titanium (Ti).

The second circuit insulating layer VIA2 may cover the first circuit insulating layer VIA1 and the third electrode ED3. The second circuit insulating layer VIA2 may include an organic film and/or an inorganic film. The second circuit insulating layer VIA2 may provide a planar surface. However, the number of circuit insulating layers VIA1, VIA2 is not limited thereto. The number of circuit insulating layers VIA1, VIA2 may be changed as desired.

The light-emitting diode (LED) layer ELL may include a pixel defining layer PDL and a light-emitting diode LD. The pixel defining layer PDL may cover at least a portion of the circuit layer CL. The pixel defining layer PDL may be disposed on at least a portion of the second circuit insulating layer VIA2. That is, an opening OP may be defined in the pixel defining layer PDL. The light-emitting diode LD may be configured to emit light. The light-emitting diode LD may be disposed in the opening OP of the pixel defining layer PDL. The light-emitting diode LD may include an anode electrode AE, a hole functional layer HFL, a light-emitting layer EML, an electron functional layer EFL, and a cathode electrode CE.

The anode electrode AE may be disposed on a portion of the second circuit insulating layer VIA2. In an embodiment, the anode electrode AE may be disposed in the opening OP. The anode electrode AE may be electrically connected to the third electrode ED3 through a contact hole defined in the second circuit insulating layer VIA2. Therefore, the anode electrode AE may receive electrical signals from the first transistor T1 and the second transistor T2.

The structures of the first transistor T1 and the second transistor T2 illustrated in FIG. 2A are merely examples, and the structures of the first transistor T1 and the second transistor T2 are not limited to those shown in FIG. 2A. In FIG. 2A, the first transistor T1 is illustrated as if it directly contacts the anode electrode AE of the light-emitting diode LD through the second electrode ED2 and the third electrode ED3; however, this is a cross-sectional representation and is illustrated in this manner for simplicity. In practice, the first transistor T1 may be connected to the anode electrode AE of the light-emitting diode LD through another transistor. However, the present disclosure is not limited thereto, and in another embodiment of the present disclosure, the first transistor T1 may directly contact the anode electrode AE of the light-emitting diode LD through the second electrode ED2 and the third electrode ED3.

The hole functional layer HFL may be disposed on the anode electrode AE. The hole functional layer HFL may assist the movement of holes generated from the anode electrode AE. That is, the hole functional layer HFL may more readily receive holes injected from the anode electrode AE and better facilitate the movement of holes. The hole functional layer HFL may have a multilayer structure. In an embodiment, for example, the hole functional layer HFL may further include a hole injection layer and a hole transport layer.

The light-emitting layer EML may be disposed in the opening OP and on the hole functional layer HFL. Light may be emitted from the light-emitting layer EML. The light-emitting layer EML may include an organic light-emitting material or quantum dots. Accordingly, the light-emitting diode LD may be an organic light-emitting diode (OLED) or a quantum dot light-emitting diode (QLED).

The electron functional layer EFL may be disposed on the light-emitting layer EML. The electron functional layer EFL may assist the movement of electrons generated from the cathode electrode CE. That is, the electron functional layer EFL may more readily receive electrons injected from the cathode electrode CE and better facilitate the movement of electrons. The electron functional layer EFL may have a multilayer structure. In an embodiment, for example, the electron functional layer EFL may include an electron injection layer and an electron transport layer.

The cathode electrode CE may be disposed on the electron functional layer EFL. The cathode electrode CE has low resistance, thereby readily facilitating the flow of current.

The encapsulation layer TFE may seal the light-emitting diode LD and protect the light-emitting diode LD from external oxygen or moisture. The encapsulation layer TFE may include at least one selected from a first inorganic encapsulation layer CVD1, an organic encapsulation layer MN, and a second inorganic encapsulation layer CVD2. The first inorganic encapsulation layer CVD1 may include a first inorganic material and may cover the LED layer ELL. The organic encapsulation layer MN may include an organic insulating material and may cover at least a portion of the first inorganic encapsulation layer. The second inorganic encapsulation layer CVD2 may include a second inorganic material and may cover the organic encapsulation layer.

In an embodiment, as shown in FIG. 2A, the encapsulation layer TFE may include two inorganic encapsulation layers CVD1, CVD2 and one organic encapsulation layer MN; however, the present disclosure is not limited thereto. In another embodiment, for example, the encapsulation layer TFE may include three inorganic encapsulation layers and two organic encapsulation layers. In such an embodiment, the inorganic encapsulation layers and the organic encapsulation layers may be alternately stacked.

The touch insulation layer IL may be disposed on the encapsulation layer TFE and may cover the encapsulation layer TFE. In an embodiment of the present disclosure, the repair device RPM may form a protective member PRT on the touch insulation layer IL. The protective member PRT may include a metallic material. In an embodiment, for example, the metallic material may include at least one selected from aluminum (Al), copper (Cu), molybdenum (Mo), tungsten (W), silver (Ag), gold (Au), nickel (Ni), indium (In), indium tin oxide (ITO), and chromium (Cr).

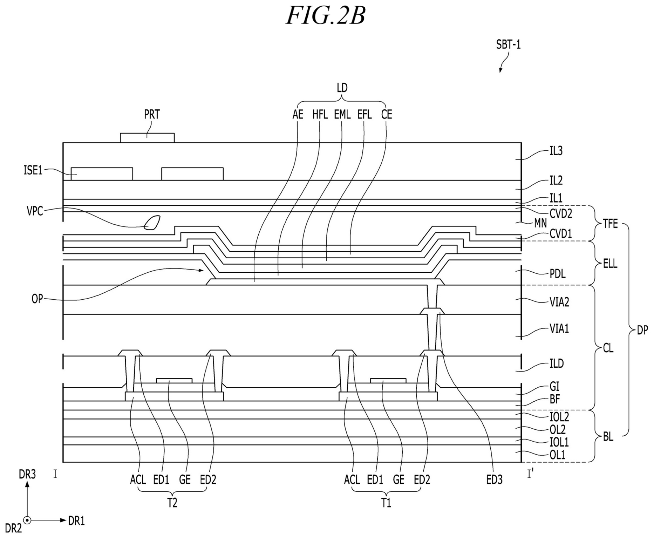

FIG. 2B is a cross-sectional view illustrating a substrate SBT-1 according to an embodiment of the present disclosure. Referring to FIGS. 2A and 2B, in an embodiment of the present disclosure, a length of a predetermined structure VPC measured in a first direction DR1 may be smaller than a length of a protective member PRT measured in the first direction DR1. A second direction DR2 may be a direction perpendicular to the first direction DR1, and a third direction DR3 may be a direction perpendicular to both the first direction DR1 and the second direction DR2. The third direction DR3 may be a thickness direction of the substrate SBT-1.

In the present specification, a defect refers to a state in which the predetermined structure VPC is present in the encapsulation layer TFE. The predetermined structure VPC may be an unintended foreign substance. In an embodiment, for example, the foreign substance may include at least one selected from photolithography resist residue, polyimide (PI) residue, polymer residue, oxide particles, silicon (Si) particles, and metal fragments.

Referring to FIG. 2B, the substrate SBT-1 may include the display panel DP, a lower touch insulation layer IL1, an intermediate touch insulation layer IL2, a first touch-detection electrode ISE1, and an upper touch insulation layer IL3. The lower touch insulation layer IL1 may be disposed on the encapsulation layer TFE. The intermediate touch insulation layer IL2 may be disposed on the lower touch insulation layer IL1. A thickness of the intermediate touch insulation layer IL2 may be greater than a thickness of the lower touch insulation layer IL1. In an embodiment, for example, the lower touch insulation layer IL1 may have a thickness of about 500 angstrom (Å), and the intermediate touch insulation layer IL2 may have a thickness of about 1,500 Å. The first touch-detection electrode ISE1 may be disposed on the lower touch insulation layer IL1. The upper touch insulation layer IL3 may be disposed on the first touch-detection electrode ISE1.

In an embodiment of the present disclosure, the repair device RPM may form the protective member PRT on the upper touch insulation layer IL3. The protective member PRT may include a metallic material.

In an embodiment of the present disclosure, the touch insulation layer IL of FIG. 2A may include at least one selected from the lower touch insulation layer IL1 and the intermediate touch insulation layer IL2 of FIG. 2B.

In an embodiment, as shown in FIGS. 2A and 2B, the protective member PRT may be disposed on the touch insulation layer IL or the upper touch insulation layer IL3, but this is merely an example and the position of the protective member PRT is not limited thereto. In another embodiment, for example, the protective member PRT may be disposed on the lower touch insulation layer IL1 or on the intermediate touch insulation layer IL2. The other description of the substrate SBT-1 is substantially the same as that described in connection with FIG. 2A and thus will not be provided redundantly.

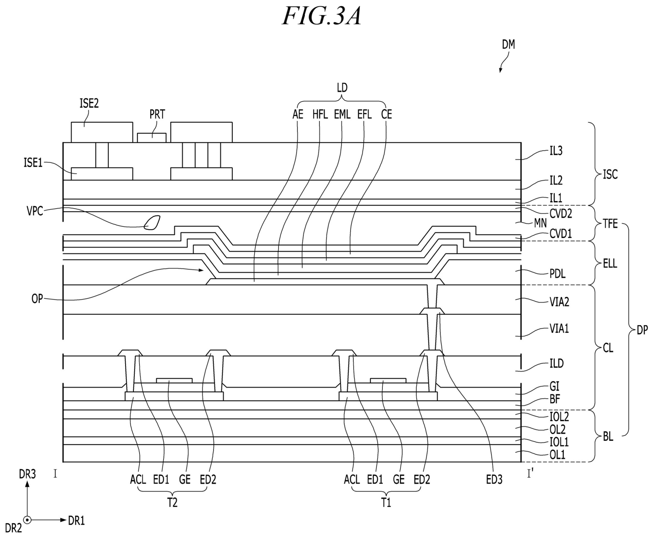

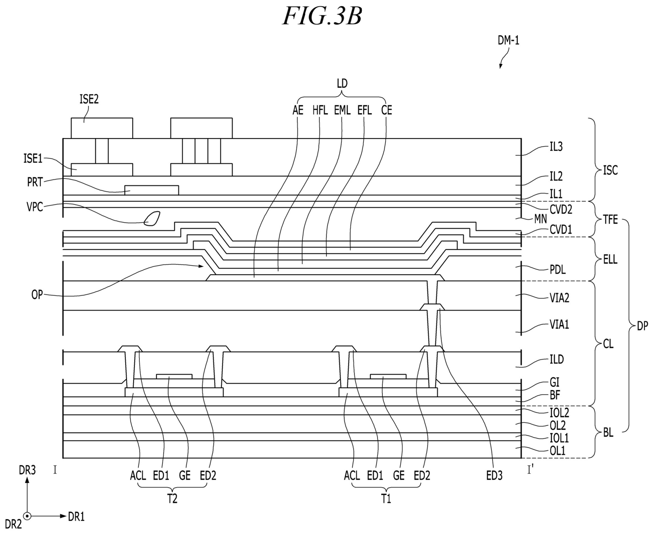

FIG. 3A is a cross-sectional view illustrating a display module DM manufactured using the substrate SBT of FIG. 2A. FIG. 3B is a cross-sectional view illustrating a display module DM-1 manufactured using the substrate SBT-1 of FIG. 2B.

Referring to FIGS. 3A and 3B, the display modules DM, DM-1 may include the display panel DP and a touch-detection circuit ISC. The touch-detection circuit ISC of the display module DM may be formed by performing the repair process and subsequent processes on the touch insulation layer IL of FIG. 2A.

The touch-detection circuit ISC may be configured to generate a touch-detection signal in response to an external input. The touch-detection circuit ISC may include a lower touch insulation layer IL1, an intermediate touch insulation layer IL2, a first touch-detection electrode ISE1, an upper touch insulation layer IL3, and a second touch-detection electrode ISE2.

The lower touch insulation layer IL1 may be disposed on the encapsulation layer TFE. The intermediate touch insulation layer IL2 may be disposed on the lower touch insulation layer IL1.

The first touch-detection electrode ISE1 may be disposed on the intermediate touch insulation layer IL2. The first touch-detection electrode ISE1 may have a single-layer structure or a multilayer structure. In an embodiment where the first touch-detection electrode ISE1 has a single-layer structure, the first touch-detection electrode ISE1 may include a metal layer or a transparent electrode. The metal layer may include molybdenum, silver, titanium, copper, aluminum, and/or alloys thereof. The transparent electrode may include a transparent conductive oxide, a conductive polymer such as PEDOT, metal nanowires, or graphene. The transparent conductive oxide may include indium tin oxide (ITO), indium zinc oxide (IZO), zinc oxide (ZnO), or indium tin zinc oxide (ITZO).

In an embodiment where the first touch-detection electrode ISE1 has a multilayer structure, the first touch-detection electrode ISE1 may have a structure in which titanium (Ti), aluminum (Al), and titanium (Ti) are sequentially stacked.

The upper touch insulation layer IL3 may be disposed on the first touch-detection electrode ISE1. Each of the lower touch insulation layer IL1, the intermediate touch insulation layer IL2, and the upper touch insulation layer IL3 may have a single-layer structure or a multilayer structure and may include an inorganic material or a composite material. The inorganic material may include at least one selected from aluminum oxide, titanium oxide, silicon oxide, silicon oxynitride, zirconium oxide, and hafnium oxide.

In an embodiment of the present disclosure, the upper touch insulation layer IL3 may be thicker than the intermediate touch insulation layer IL2, and the intermediate touch insulation layer IL2 may be thicker than the lower touch insulation layer IL1.

In an embodiment, at least one selected from the lower touch insulation layer IL1, the intermediate touch insulation layer IL2, and the upper touch insulation layer IL3 may be omitted.

The second touch-detection electrode ISE2 may be disposed on the upper touch insulation layer IL3 and may have a single-layer structure or a multilayer structure.

In an embodiment where the second touch-detection electrode ISE2 has a single-layer structure, the second touch-detection electrode ISE2 may include a metal layer or a transparent electrode. The metal layer may include molybdenum, silver, titanium, copper, aluminum, and/or alloys thereof. The transparent electrode may include a transparent conductive oxide, a conductive polymer such as PEDOT, metal nanowires, or graphene. The transparent conductive oxide may include ITO, IZO, ZnO, or ITZO.

In an embodiment where the second touch-detection electrode ISE2 has a multilayer structure, the second touch-detection electrode ISE2 may have a structure in which titanium (Ti), aluminum (Al), and titanium (Ti) are sequentially stacked.

A capacitor may be formed between the first touch-detection electrode ISE1 and the second touch-detection electrode ISE2. The capacitance of the capacitor may change in response to an external input. Accordingly, a touch-detection signal may be generated, and the position at which the external input is applied may be determined using the touch-detection signal.

In an embodiment, as shown in FIGS. 3A and 3B, the first touch-detection electrode ISE1 may be disposed on the intermediate touch insulation layer IL2; however, this is merely an example and the position of the first touch-detection electrode ISE1 is not limited thereto. In another embodiment of the present disclosure, the first touch-detection electrode ISE1 may be disposed between the lower touch insulation layer IL1 and the intermediate touch insulation layer IL2.

Referring to FIGS. 3A and 3B, in an embodiment of the present disclosure, the protective member PRT may be disposed on the upper touch insulation layer IL3 or between the lower touch insulation layer IL1 and the intermediate touch insulation layer IL2.

In an embodiment, as shown in FIG. 3A, the protective member PRT and the second touch-input electrode ISE2 may be disposed in (or directly on) a same layer as each other. Accordingly, when the protective member PRT comes into contact with the second touch-input electrode ISE2, a short may occur. In another embodiment, as shown in FIG. 3B, the protective member PRT may be disposed in (or directly on) a different layer from the second touch-input electrode ISE2, the above-described short may be effectively prevented.

Referring back to FIG. 1B, the processor PRC is configured to perform processing using the defect-detection artificial intelligence (AI) model SMD. The defect-detection AI model SMD is configured to analyze images captured by the imaging device CMR and locate positions at which defects occur in the substrate SBT. In an embodiment, for example, the defect-detection AI model SMD may be an artificial intelligence model using at least one selected from Fully Convolutional Networks (FCN), DeepLab (DeepLabV1 to V3/V3+), YOLO (You Only Look Once), Faster R-CNN, SSD (Single Shot MultiBox Detector), PSPNet (Pyramid Scene Parsing Network), U-Net, SegNet, Mask R-CNN, YOLACT (You Only Look At Coefficients), BlendMask, Panoptic FPN (Feature Pyramid Network), Panoptic-DeepLab, and UPSNet (Unified Panoptic Segmentation Network).

The automatic repair system RPS may operate differently depending on whether the processor PRC successfully locates the position at which a defect occurs in the substrate SBT using the defect-detection AI model SMD.

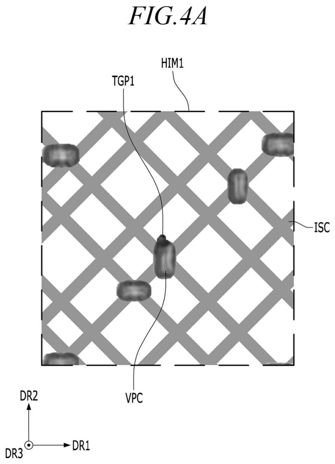

Hereinafter, a case in which the processor PRC successfully locates a position at which a defect has occurred in the substrate SBT will be described in detail with reference to FIGS. 4A to 4C.

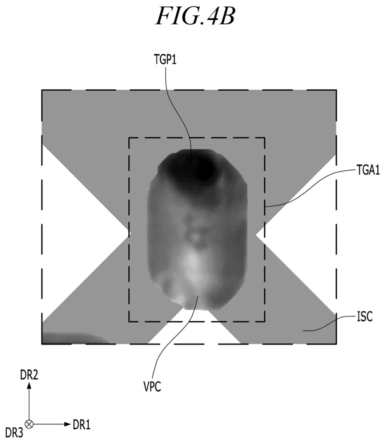

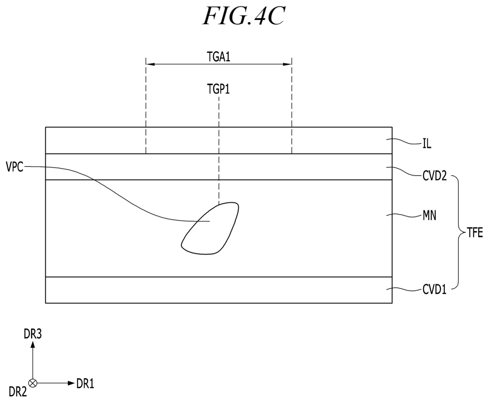

FIG. 4A may be a first high-magnification image HIM1 generated by the imaging device CMR by capturing a first portion of the substrate SBT. FIG. 4B is an enlarged view of a portion of FIG. 4A. FIG. 4C is a cross-sectional view illustrating the substrate SBT corresponding to a first target region TGA1.

The touch-detection electrode ISE in FIGS. 4A to 4C may be at least one selected from the first touch-detection electrode ISE1 and the second touch-detection electrode ISE2 of FIGS. 3A and 3B.

The target region may be defined on the image and may correspond to a portion of the substrate SBT on which the repair process is to be performed. The shape and size of the target region may be freely changed depending on the type and conditions of the repair process.

Referring to FIG. 4A, the imaging device CMR may capture a first portion of the substrate SBT to generate the first high-magnification image HIM1. In an embodiment, for example, the first high-magnification image HIM1 may be an image magnified by 50 times.

Referring to FIG. 4B, the defect-detection artificial intelligence (AI) model SMD may locate a position at which a defect has occurred in the substrate SBT (or a position of the predetermined structure VPC in the first portion) using contrast differences or gray levels in the image. That is, the defect-detection AI model SMD may analyze the first high-magnification image HIM1 and locate a first target position TGP1 at which a defect has occurred in the substrate SBT.

When the processor PRC locates the first target position TGP1 using the defect-detection AI model SMD, the processor PRC may define a first target region TGA1 including the first target position TGP1.

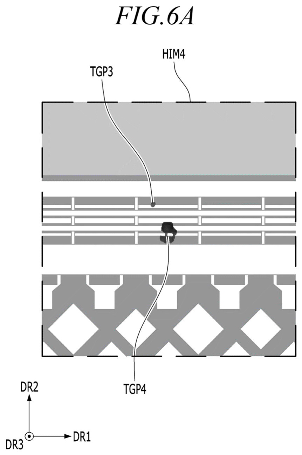

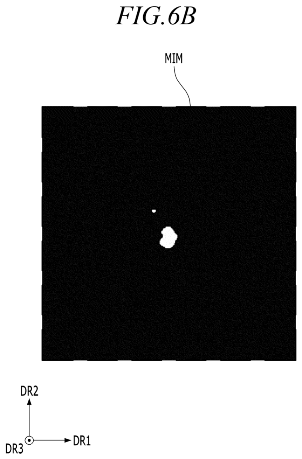

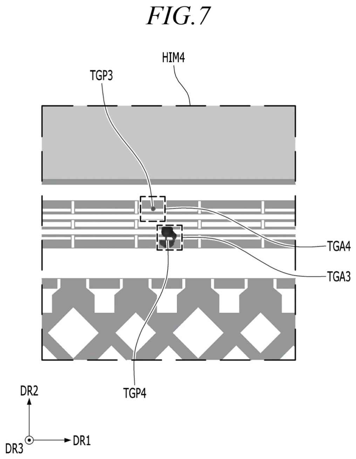

Thereafter, the repair device RPM may dispose or provide a metallic material on a portion of the touch insulation layer IL corresponding to the first target region TGA1. The process of defining the first target region TGA1 will be described in detail with reference to FIGS. 6A, 6B, and 7.

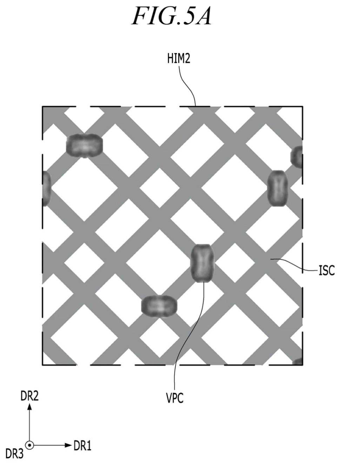

Hereinafter, a case in which the processor PRC fails to locate a position at which a defect has occurred in the substrate SBT will be described in detail with reference to FIGS. 5A to 5C.

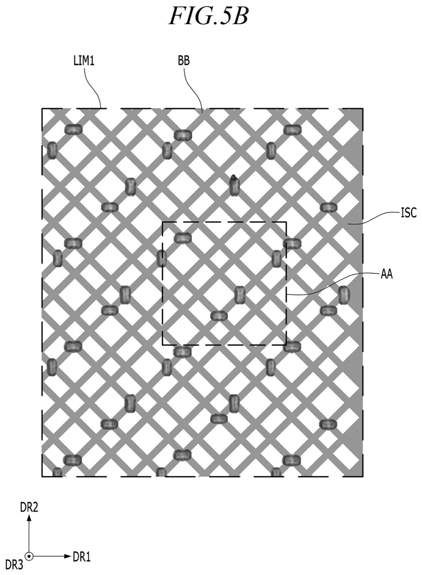

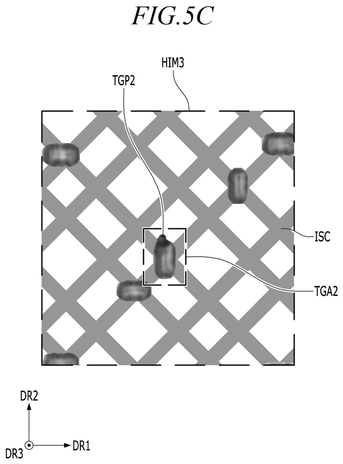

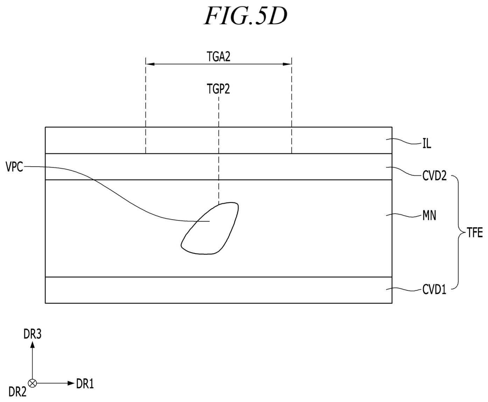

FIG. 5A may be a second high-magnification image HIM2 generated by the imaging device CMR by capturing a second portion of the substrate SBT. FIG. 5B may be a first low-magnification image LIM1 generated by the imaging device CMR by capturing a third portion of the substrate SBT. FIG. 5C may be a third high-magnification image HIM3 generated by the imaging device CMR by capturing a fourth portion of the substrate SBT. FIG. 5D is a cross-sectional view illustrating the substrate SBT corresponding to a second target region TGA2.

Referring to FIG. 5A, the imaging device CMR may capture the second portion of the substrate SBT to generate the second high-magnification image HIM2. In an embodiment, for example, the second high-magnification image HIM2 may be an image magnified by 50 times.

Referring to FIG. 5B, when the processor PRC fails to locate a target position at which a defect has occurred by analyzing the second high-magnification image HIM2 using the defect-detection AI model SMD, the imaging device CMR may capture a third portion of the substrate SBT to generate the first low-magnification image LIM1. The third portion may include the second portion, and an area of the third portion may be larger than an area of the second portion.

That is, even when the processor PRC fails to locate the target position at which a defect has occurred by analyzing the second high-magnification image HIM2, the processor PRC may analyze the first low-magnification image LIM1 to attempt to locate the target position again. Through such a process, the defect detection success rate may be improved.

The third portion may include the fourth portion of the substrate SBT, and the fourth portion may be a portion of the substrate SBT at which a defect has occurred.

Referring to FIGS. 5B and 5C, the processor PRC may analyze the first low-magnification image LIM1 using the defect-detection AI model SMD to relocate the position at which a defect has occurred, and the imaging device CMR may capture the fourth portion of the substrate SBT to generate the third high-magnification image HIM3. In an embodiment, for example, the third high-magnification image HIM3 may be an image magnified by 50 times.

Referring to FIGS. 5A to 5C, a first portion AA of the first low-magnification image LIM1 may correspond to the second high-magnification image HIM2, and another portion BB may correspond to the third high-magnification image HIM3.

Referring to FIGS. 5C and 5D, the processor PRC may analyze the third high-magnification image HIM3 using the defect-detection AI model SMD to locate a second target position TGP2 at which a defect has occurred. Moreover, the processor PRC may define a second target region TGA2 including the second target position TGP2. Thereafter, the repair device RPM may provide a metallic material on a portion of the touch insulation layer IL corresponding to the second target region TGA2.

Hereinafter, the process of defining the third target region TGA3 and the fourth target region TGA4 will be described in detail with reference to FIGS. 6A, 6B, and 7.

FIG. 6A may be a fourth high-magnification image HIM4 generated by the imaging device CMR by capturing the substrate SBT. FIG. 6B illustrates an example of a mask image MIM generated by the processor PRC using the fourth high-magnification image HIM4. FIG. 7 illustrates an example of the third target region TGA3 and the fourth target region TGA4 defined by the processor PRC using the mask image MIM.

When the processor PRC locates multiple target positions at which defects have occurred in the substrate SBT from the fourth high-magnification image HIM4, the processor PRC may define multiple target regions.

Referring to FIGS. 6A and 6B, the processor PRC may analyze the fourth high-magnification image HIM4 using the defect-detection AI model SMD to locate a third target position TGP3 and a fourth target position TGP4 at which defects have occurred. In addition, the processor PRC may extract portions of the fourth high-magnification image HIM4 corresponding to the defects to generate the mask image MIM. In an embodiment, the mask image MIM may be a grayscale or binary image used to selectively conceal or reveal the portions of the fourth high-magnification image HIM4 corresponding to the defects.

Referring to FIG. 7, the processor PRC may define the third target region TGA3 and the fourth target region TGA4 in the fourth high-magnification image HIM4 using the mask image MIM. The third target region TGA3 may include the third target position TGP3, and the fourth target region TGA4 may include the fourth target position TGP4.

The processor PRC may define the third target region TGA3 and the fourth target region TGA4 in the fourth high-magnification image HIM4 using at least one selected from an iterative algorithm and a region-defining AI model DMD. The target region may be defined by reflecting the target position and the conditions for performing the repair process. In an embodiment, for example, where the repair process is a process of providing a metallic material, the plurality of target regions may be defined not to overlap each other to effectively prevent defects caused by overlapping processing.

The iterative algorithm refers to an algorithm that gradually derives results using loops to solve a problem. When the repair process is relatively simple, it may be easier for the processor PRC to define the target region using the iterative algorithm.

The region-defining AI model DMD may be an AI model trained using a deep-learning-based reinforcement learning method. The region-defining AI model DMD may be an AI model using at least one selected from Fully Convolutional Networks (FCN), DeepLab (DeepLabV1 to V3/V3+), YOLO (You Only Look Once), Faster R-CNN, SSD (Single Shot MultiBox Detector), PSPNet (Pyramid Scene Parsing Network), U-Net, SegNet, Mask R-CNN, YOLACT (You Only Look At Coefficients), BlendMask, Panoptic FPN (Feature Pyramid Network), Panoptic-DeepLab, and UPSNet (Unified Panoptic Segmentation Network).

The more complex the repair process is, the more advantageous it may be for the processor PRC to define the target region using the iterative algorithm. Conversely, the simpler the repair process is, the more desirable it may be for the processor PRC to define the target region using the region-defining AI model DMD.

After the target region is defined, the repair device RPM may form a protective member PRT on a portion of the touch insulation layer IL corresponding to the target region. The protective member PRT may include a metallic material.

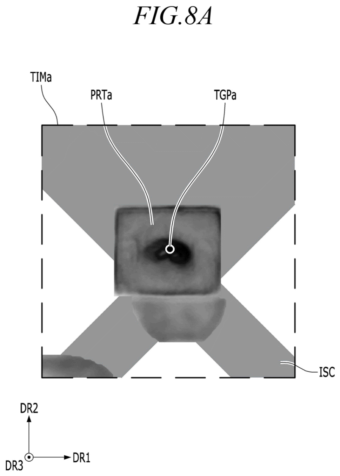

Each of FIGS. 8A to 8E may be a post-inspection image TIM generated by the imaging device CMR by capturing a target region after the repair process has been performed.

The processor PRC may determine whether the substrate SBT has been converted into a non-defective substrate after the repair process using the post-inspection AI model TMD. Through such processes, the process of determining whether the substrate SBT has been converted into a non-defective substrate after the repair process may be effectively automated.

In an embodiment, for example, the post-inspection AI model TMD may be an artificial intelligence model using at least one selected from FCN (Fully Convolutional Networks), DeepLab (DeepLabV1 to V3/V3+), YOLO (You Only Look Once), Faster R-CNN, SSD (Single Shot MultiBox Detector), PSPNet (Pyramid Scene Parsing Network), U-Net, SegNet, Mask R-CNN, YOLACT (You Only Look At Coefficients), BlendMask, Panoptic FPN (Feature Pyramid Network), Panoptic-DeepLab, and UPSNet (Unified Panoptic Segmentation Network).

The processor PRC may perform processing using the post-inspection AI model TMD, and the post-inspection AI model TMD may analyze the post-inspection image TIM to determine whether a target position TGP overlaps with a protective member PRT. The target position TGP may be a position of a portion of the predetermined structure VPC that is farthest from the base member BL.

As illustrated in FIG. 8A, when the target position TGPa overlaps the protective member PRTa, the substrate SBT may be determined to have been converted into a non-defective substrate.

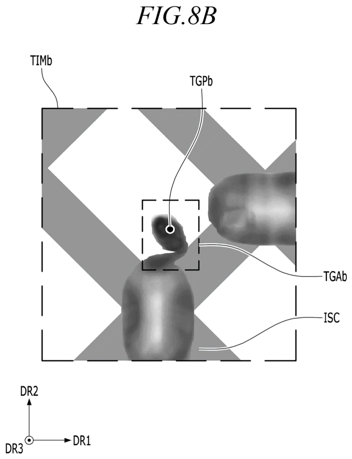

As illustrated in FIG. 8B, when no protective member is formed in a target region TGAb, it may be determined that the repair process has not been performed. When the material for the repair process is insufficient, the protective member may not be formed in the target region TGAb. Accordingly, the repair device RPM may provide a metallic material in the target region TGAb to form the protective member.

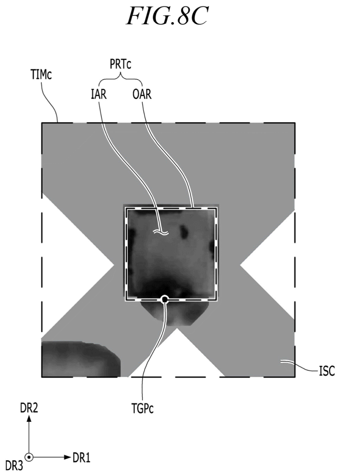

Referring to FIG. 8C, an inner region IAR and an outer region OAR surrounding the inner region may be defined in the protective member PRTc when viewed in a plan view. The target position TGPc may overlap the inner region IAR and may not overlap the outer region OAR.

In the present specification, the outline of the metallic material refers to the outer region OAR defined in the protective member PRT.

The processor PRC may analyze the post-inspection image TIMc using the post-inspection AI model TMD to determine whether the target position TGP overlaps the outline of the metallic material. That is, the processor PRC may determine whether the target position TGP overlaps the outer region OAR of the protective member PRT.

As illustrated in FIG. 8C, when the target position overlaps the outer region OAR of the protective member PRT, the substrate SBT may be determined not to have been converted into a non-defective substrate. In such a case, the post-inspection image TIMc may be used as training data for improving the post-inspection AI model TMD.

When multiple target regions are provided, the repair device RPM may provide a metallic material on portions of the touch insulation layer IL corresponding to the multiple target regions. Accordingly, multiple protective members PRT may be formed.

The processor PRC may analyze the post-inspection image TIM using the post-inspection AI model TMD to determine whether there are portions of the touch insulation layer IL on which metallic material has been disposed more than once. That is, the processor PRC may determine whether there are protective members PRT overlapping each other among the multiple protective members PRT.

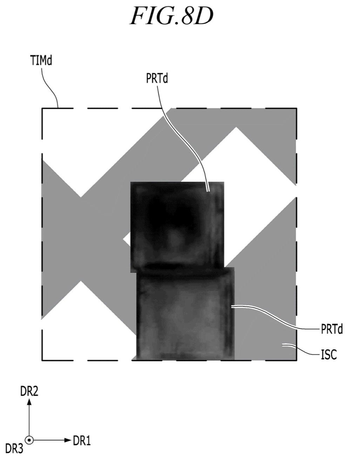

As illustrated in FIG. 8D, when two or more protective members PRTd overlap each other, the substrate SBT may be determined not to have been converted into a non-defective substrate. In such a case, the post-inspection image TIMd may be used as training data for improving the post-inspection AI model TMD.

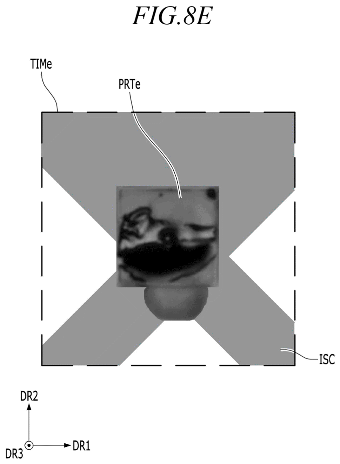

As illustrated in FIG. 8E, when the shape of the protective member PRTe is incomplete, the quality of the film formation through the repair process may be determined to be low. In such a case, the operation of the repair device RPM may be stopped, and the automatic repair system RPS may provide an alarm to the user.

The processor PRC may perform processing using the image-generation AI model VMD. The image-generation AI model VMD may be a diffusion-based artificial intelligence model that generates virtual training data using an input image. The post-inspection AI model TMD may be trained in a supervised learning manner based on virtual training data generated by the image-generation AI model VMD. In an embodiment, for example, the image-generation AI model VMD may be an artificial intelligence model using at least one selected from Stable Diffusion, LDM (Latent Diffusion Model), and DeepFloyd IF.

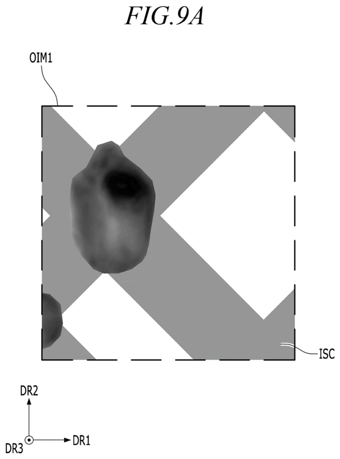

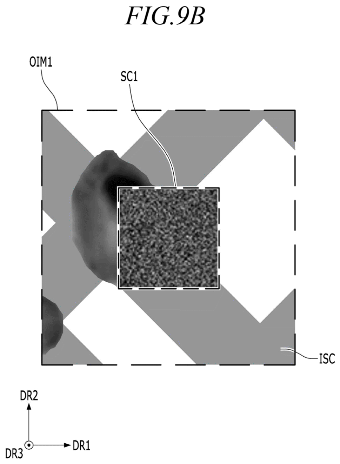

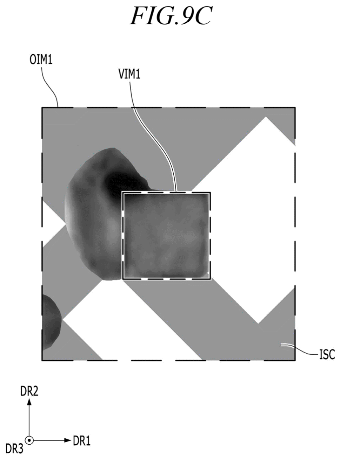

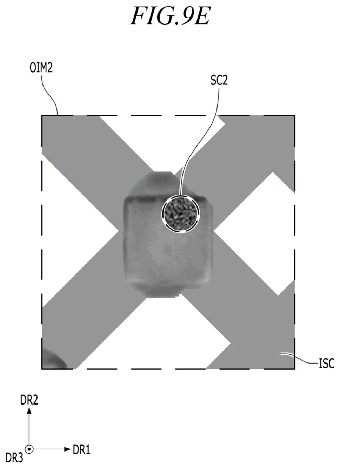

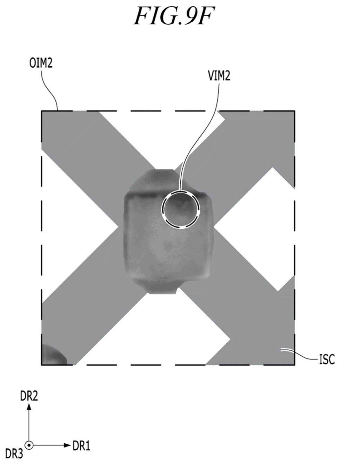

Hereinafter, a process of generating virtual training data will be described with reference to FIGS. 9A to 9F. FIGS. 9A to 9F illustrate a process of generating virtual training data.

In an embodiment, training data that includes both images of substrates SBT that have successfully been converted into non-defective substrates after the repair process and images of substrates SBT that have failed to be converted into non-defective substrates after the repair process may be used to automate the repair post-inspection using the post-inspection AI model TMD.

However, the initial occurrence rate of defects in the substrate SBT requiring a repair process is not high, and the failure rate of converting substrates SBT into non-defective substrates even after the repair process is also not high. That is, it may be difficult to sufficiently secure training data for the post-inspection AI model TMD using only actually collected images. Therefore, the present disclosure proposes a method of generating virtual training data using the image-generation AI model VMD and improving the functionality of the post-inspection AI model TMD using the virtual training data.

Referring to FIGS. 9A to 9C, the image-generation AI model VMD may generate a first virtual image VIM1 in a first region SC1 of a first original image OIM1 that is input. In an embodiment of the present disclosure, the first region SC1 is a partial region of the first original image OIM1 and may be designated by a user. In an embodiment, for example, each of the first region SC1 and the first virtual image VIM1 may be rectangular.

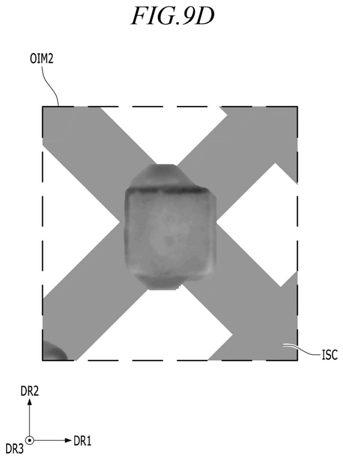

Referring to FIGS. 9D to 9F, the image-generation AI model VMD may generate a second virtual image VIM2 in a second region SC2 of a second original image OIM2 that is input. In an embodiment of the present disclosure, the second region SC2 is a partial region of the second original image OIM2 and may be designated by a user. In an embodiment, for example, each of the second region SC2 and the second virtual image VIM2 may be circular. In an embodiment of the present disclosure, the second region SC2 may be different from the first region SC1.

In an embodiment of the present disclosure, the shape and size of each of the first region SC1 and the second region SC2 may be freely changed according to the type and conditions of the repair process.

In order to more accurately inspect a specific type of defect that occurs frequently, the user may set the first region SC1 and the second region SC2 to generate the first virtual image VIM1 and the second virtual image VIM2 corresponding to the defects described above. Thereafter, the post-inspection AI model TMD trained in a supervised learning manner using the first virtual image VIM1 and the second virtual image VIM2 may determine whether the substrate SBT has been converted into a non-defective substrate with higher accuracy for the defects described above.

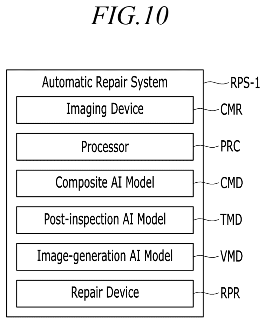

FIG. 10 is an example block diagram illustrating an automatic repair system RPS-1 according to an embodiment of the present disclosure. Referring to FIG. 10, a composite artificial intelligence (AI) model CMD of the automatic repair system RPS-1 may perform both the function of the defect-detection AI model SMD (FIG. 1B) and the function of the region-defining AI model DMD (FIG. 1B).

The processor PRC may perform processing using the composite AI model CMD. The composite AI model CMD may locate the first target position TGP1 from a high-magnification image, locate the second target position TGP2 from a low-magnification image, and define a target region. The defect-detection AI model SMD may analyze an image captured by the imaging device CMR to locate a position at which a defect has occurred in the substrate SBT. In an embodiment, for example, the composite AI model CMD may be an artificial intelligence model using at least one selected from FCN (Fully Convolutional Networks), DeepLab (DeepLabV1 to V3/V3+), YOLO (You Only Look Once), Faster R-CNN, SSD (Single Shot MultiBox Detector), PSPNet (Pyramid Scene Parsing Network), U-Net, SegNet, Mask R-CNN, YOLACT (You Only Look At Coefficients), BlendMask, Panoptic FPN (Feature Pyramid Network), Panoptic-DeepLab, and UPSNet (Unified Panoptic Segmentation Network).

The description of other functions of the composite AI model CMD is substantially the same as that described with reference to FIGS. 4A to 5D and thus will therefore be omitted.

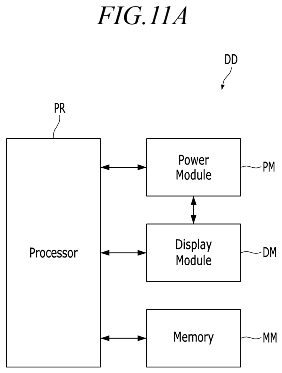

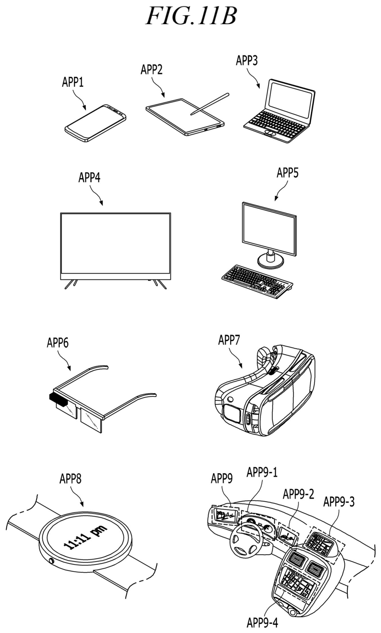

FIG. 11A is a block diagram illustrating an electronic device DD according to an embodiment of the present disclosure. FIG. 11B illustrates various forms of the electronic device DD according to embodiments of the present disclosure. Referring to FIG. 11A, the electronic device DD according to an embodiment may include a display panel DP, a processor PR, a memory MM, and a power module PM.

The processor PR may include at least one selected from a central processing unit (CPU), an application processor (AP), a graphic processing unit (GPU), a communication processor (CP), an image signal processor (ISP), and a controller.

The memory MM may have stored therein data information for operating the processor PR or the display module DM. When the processor PR executes an application stored in the memory MM, image data signals and/or input control signals may be transferred to the display module DM, which then may process the received signals to output image information through a display screen.

The power module PM may include a power supply module, such as a power adapter or a battery device, and a power conversion module configured to convert the power supplied by the power supply module to generate the power used for operating the electronic device DD.

At least one of the components of the above-described electronic device DD may be included in a display device according to the above-described embodiments. Also, among individual modules functionally included in one module, some may be included in the display device, while others may be provided separately from the display device. In an embodiment, for example, the display module DM may include the display panel DP, and the processor PR, the memory MM, and the power module PM may be provided in another device within the electronic device DD, rather than in the display device.

Referring to FIG. 11B, various electronic devices DD to which the display module DM according to embodiments of the present disclosure is applied may include not only image display electronic devices, such as a smartphone APP1, a tablet personal computer (PC) APP2, a laptop computer APP3, a television (TV) APP4, and a desktop monitor APP5, but also wearable electronic devices including the display module DM, such as smart glasses APP6, a head-mounted display APP7, and a smart watch APP8, as well as automotive electronic devices APP9 to APP9-4 including the display panel, such as an instrument panel, a center fascia, a dashboard-mounted center information display (CID), or a room mirror display.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. An automatic repair system (RPS) comprising:
a stage (STG) which is configured to support a substrate (SBT) including a display panel (DP) and a touch insulation layer (IL) disposed on the display panel (DP);
an imaging device (CMR) which is configured to capture a first portion of the substrate (SBT) and generate a high-magnification image;
a processor (PRC) which is configured to perform processing using a defect-detection artificial intelligence, AI, model (SMD) capable of analyzing an image captured by the imaging device (CMR) and locating a position at which a defect occurs in the substrate (SBT); and
a repair device (RPM) which is configured to provide a metallic material on the touch insulation layer (IL),
wherein, when the processor (PRC) locates a first target position (TGP1) at which a defect occurs on the substrate (SBT) from the high-magnification image using the defect-detection AI model (SMD), the processor (PRC) is configured to define a first target region (TGA1) including the first target position (TGP1), and the repair device (RPM) is configured to provide the metallic material on a portion of the touch insulation layer (IL) corresponding to the first target region (TGA1), and
wherein, when the processor (PRC) fails to locate the first target position (TGP1) at which the defect occurs on the substrate (SBT) from the high-magnification image using the defect-detection AI model (SMD), the imaging device (CMR) is configured to capture a second portion of the substrate (SBT) including the first portion and generate a low-magnification image, wherein the second portion has a larger area than the first portion.

2. The automatic repair system (RPS) of claim 1, wherein, when the processor (PRC) locates a second target position (TGP2) at which a defect occurs on the substrate (SBT) from the low-magnification image using the defect-detection AI model (SMD), the processor (PRC) is configured to define a second target region (TGA2) including the second target position (TGP2), and the repair device (RPM) is configured to provide the metallic material on a portion of the touch insulation layer (IL) corresponding to the second target region (TGA2).

3. The automatic repair system (RPS) of claim 2, wherein the processor (PRC) is configured to define each of the first target region (TGA1) and the second target region (TGA2) using at least one selected from an iterative algorithm and a region-defining artificial intelligence, AI, model (DMD), and
wherein the region-defining AI model (DMD) is an artificial intelligence model trained using a deep-learning-based reinforcement learning method.

4. The automatic repair system (RPS) of one of the preceding claims, wherein the imaging device (CMR) is configured to capture a portion of the touch insulation layer (IL) corresponding to the first target region (TGA1) to generate a post-inspection image, after the metallic material is provided by the repair device (RPM), and
wherein the processor (PRC) is configured to perform processing using a post-inspection artificial intelligence, AI, model (TMD) configured to analyze the post-inspection image and determines whether the first target position (TGP1) overlaps the metallic material.

5. The automatic repair system (RPS) of claim 4, wherein, the repair device (RPM) is configured to provide the metallic material in the first target region (TGA1) when it is determined that the metallic material is not provided in the first target region (TGA1).

6. The automatic repair system (RPS) of claim 4, wherein, when multiple first target regions (TGA1) are provided, the repair device (RPM) is configured to provide the metallic material on portions of the touch insulation layer (IL) corresponding to the multiple first target regions (TGA1), and the processor (PRC) is configured to analyze the post-inspection image using the post-inspection AI model (TMD) to determine whether there is a portion of the touch insulation layer (IL) on which the metallic material is provided more than once.

7. The automatic repair system (RPS) of claim 4, wherein the processor (PRC) is configured to analyze the post-inspection image using the post-inspection AI model (TMD) to determine whether the first target position (TGP1) overlaps an outline of the metallic material.

8. The automatic repair system (RPS) of one of claims 4 to 7, wherein the processor (PRC) is configured to perform processing using a diffusion-based image-generation artificial intelligence, AI, model (VMD),
wherein the image-generation AI model (VMD) is configured to generate virtual training data using an input image, and
wherein the post-inspection AI model (TMD) is configured to be trained in a supervised learning manner based on the virtual training data.

9. The automatic repair system (RPS) of claim 8,
wherein the image-generation AI model (VMD) is configured to generate a first virtual image (VIM1) in a first region (SC1) of the input image and generate a second virtual image (VIM2) in a second region (SC2) of the input image different from the first region (SC1).

10. The automatic repair system (RPS) of one of the preceding claims, wherein the display panel (DP) comprises:
a base member (BL);
a circuit layer (CL) disposed on the base member (BL) and including transistors (T1, T2);
a light-emitting diode layer (ELL) including a pixel-defining layer (PDL), in which an opening is defined, and a light-emitting layer (EML) disposed in the opening, the pixel-defining layer (PDL) covering at least a portion of the circuit layer (CL); and
an encapsulation layer (TFE) covering the light-emitting diode layer (ELL), and
wherein the touch insulation layer (IL) is disposed on the encapsulation layer (TFE).

11. The automatic repair system (RPS) of one of the preceding claims, wherein the processor (PRC) is configured to perform processing using a composite artificial intelligence, AI, model (CMD) to locate the first target position (TGP1) from the high-magnification image and defines the first target region (TGA1) including the first target position (TGP1).

12. A method of operating an automatic repair system (RPS) comprising:
a stage (STG) which is configured to support a substrate (SBT) including a display panel (DP) and a touch insulation layer (IL) disposed on the display panel (DP);
an imaging device (CMR) which is configured to capture a first portion of the substrate (SBT) and generate a high-magnification image;
a processor (PRC) which is configured to perform processing using a defect-detection artificial intelligence, AI, model (SMD) capable of analyzing an image captured by the imaging device (CMR) and locating a position at which a defect occurs in the substrate (SBT); and
a repair device (RPM) which is configured to provide a metallic material on the touch insulation layer (IL),
wherein the method comprises the following steps:
when the processor (PRC) locates a first target position (TGP1) at which a defect occurs on the substrate (SBT) from the high-magnification image using the defect-detection AI model (SMD), the processor (PRC) defines a first target region (TGA1) including the first target position (TGP1), and the repair device (RPM) provides the metallic material on a portion of the touch insulation layer (IL) corresponding to the first target region (TGA1), and
when the processor (PRC) fails to locate the first target position (TGP1) at which the defect occurs on the substrate (SBT) from the high-magnification image using the defect-detection AI model (SMD), the imaging device (CMR) captures a second portion of the substrate (SBT) including the first portion and generate a low-magnification image, wherein the second portion has a larger area than the first portion.

13. The method of claim 12, wherein, when the processor (PRC) locates a second target position (TGP2) at which a defect occurs on the substrate (SBT) from the low-magnification image using the defect-detection AI model (SMD), the processor (PRC) defines a second target region (TGA2) including the second target position (TGP2), and the repair device (RPM) provides the metallic material on a portion of the touch insulation layer (IL) corresponding to the second target region (TGA2).

14. The method of claim 13, wherein the processor (PRC) defines each of the first target region (TGA1) and the second target region (TGA2) using at least one selected from an iterative algorithm and a region-defining artificial intelligence, AI, model (DMD), and
wherein the region-defining AI model (DMD) is an artificial intelligence model trained using a deep-learning-based reinforcement learning method.

15. The method of one of claims 12 to 14, wherein the imaging device (CMR) captures a portion of the touch insulation layer (IL) corresponding to the first target region (TGA1) to generate a post-inspection image, after the metallic material is provided by the repair device (RPM), and
wherein the processor (PRC) performs processing using a post-inspection artificial intelligence, AI, model (TMD) configured to analyze the post-inspection image and determines whether the first target position (TGP1) overlaps the metallic material.
